# EUROPÄISCHE PATENTSCHRIFT

(11) **EP 1 576 675 B1**
(45) Veröffentlichungstag und Bekanntmachung des Hinweises auf die Patenterteilung: **05.07.2006**
(21) Anmeldenummer: 03813069.6
(22) Anmeldetag: 26.06.2003
(51) Int. Cl.: H01L 41/083

(54) **PIEZOAKTOR UND EIN VERFAHREN ZU DESSEN HERSTELLUNG**
PIEZO ACTUATOR AND METHOD FOR PRODUCTION THEREOF
ACTIONNEUR PIEZOELECTRIQUE ET SON PROCEDE DE PRODUCTION

(30) Priorität: 13.12.2002 DE 10258255
(43) Veröffentlichungstag der Anmeldung: 21.09.2005
(73) Patentinhaber: ROBERT BOSCH GMBH, 70442 Stuttgart (DE)
(72) Erfinder: SCHOOR, Ulrich, 70439 Stuttgart (DE)
(86) Internationale Anmeldenummer: PCT/DE2003/002130
(87) Internationale Veröffentlichungsnummer: WO 2004/055913

(56) Entgegenhaltungen:
- EP-A- 0 509 488
- EP-A- 1 107 325
- DE-A- 4 201 937
- DE-A- 10 163 005
- PATENT ABSTRACTS OF JAPAN vol. 015, no. 236 (E-1078), 18. Juni 1991 (1991-06-18) -& JP 03 072684 A (FUJI ELECTRIC CO LTD), 27. März 1991 (1991-03-27)
- PATENT ABSTRACTS OF JAPAN vol. 1998, no. 14, 31. Dezember 1998 (1998-12-31) -& JP 10 244222 A (CERATEC:KK), 14. September 1998 (1998-09-14)

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen des Hauptanspruchs.

Es ist allgemein bekannt, dass unter Ausnutzung des sogenannten Piezoeffekts ein Piezoelement aus zum Teil keramischen Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt.

Der Aufbau dieser Piezoaktoren kann hier in mehreren Schichten als sogenannte Multilayer-Piezoaktoren erfolgen, wobei die Innenelektroden, über die die elektrische Spannung aufgebracht wird, jeweils zwischen den Schichten angeordnet werden. Hierzu werden wechselseitig gestapelte Piezofolien mit aufgedruckten Elektrodenflächen als Innenelektroden, hergestellt. Dabei hat eine Folie ihren Anschluss jeweils nur auf einer Anschlussseite und auf der gegenüberliegenden Seite muss ein Rand ohne Elektrode mit einem Isolationsabstand verbleiben. Außen werden dann die beiden Seiten durch Außenelektroden verbunden. So entsteht in an sich bekannter Weise der Piezoaktor wie ein Kondensator mit vielen Platten.

Solche Multilayer-Piezoaktoren werden mit Feldstärken betrieben, die eine Isolation der offenen Kriechstrecken auf der äußeren Piezokeramik zwischen den Potentialen der Außenelektroden erforderlich machen. Geeignete Lacke oder Isolierstoffe mit guter Haftung und guten Durchschlags- und Isolationskennwerten können zum Beispiel in an sich bekannter Weise durch Sprühen oder Tauchen in bewährten Verfahren am vollen Umfang aufgebracht werden.

Es sind solche Piezoaktoren beispielsweise aus der DE 199 28 190 A1 bekannt, bei denen die Außenelektroden mit Verstärkungsmaterialien wie Wellfolien oder Gitter verstärkt sind und zum Anschluss der Innenelektroden mit Anschlüssen versehen werden.

Für einen sicheren Herstellungsprozess in der Serie dürfen die Kontaktierungszonen zum Anschließen der Außenelektroden, z.B. durch Schweißen oder Löten, nicht verschmutzt sein. Ein zuvor beschriebener Lackauftrag führt aber eventuell zur Verschmutzung der Werkzeuge des Verbindungsprozesses. Die erforderlichen verunreinigungsfreien Kontaktstellen können jedoch durch Entfernen von Lack und Lackresten nur schwer hergestellt werden.

Weiterhin ist aus der DE 199 28 180 A1 bekannt, dass im Bereich zwischen den Kontaktierungen der Außenelektroden die Piezolagen einen vorgegebenen Betrag nach innen ausgespart sind, zur Bildung einer Nut. Diese Nut verhindert beim Bearbeiten der Oberfläche des Piezoaktors und bei der Anbringung der Außenelektroden ein Verschmieren des Elektrodenmaterials zwischen den Außenelektroden und führt daher zu einer deutlichen Verbesserung der Durchschlagfestigkeit des Piezoaktors.

### Vorteile der Erfindung

Der eingangs beschriebene Piezoaktor, der beispielsweise zur Betätigung eines mechanischen Bauteils verwendbar sein kann, ist mit einem Mehrschichtaufbau von Piezolagen und dazwischen angeordneten Innenelektroden aufgebaut. Es wird eine wechselseitige Kontaktierung der Innenelektroden mit Außenelektroden vorgenommen, wobei die Bereiche zwischen den Außenelektroden mit einer geeigneten Isolation versehen sind. Erfindungemäß ist in vorteilhafter Weise die Isolation eine Schicht aus einem gut haftendem Band, vorzugsweise ein Klebeband, die einen vorgegebenen Bereich zwischen den Außenelektroden überdeckt, wobei die Haft- oder Klebeschicht gleichzeitig die Isolierschicht darstellt.

Das Band oder auch ein sog. Tape kann beispielsweise aus einem vorkonfektionierten maßgenauen Material bestehen und gemäß eines besonders vorteilhaften Herstellungsverfahrens blasenfrei aufgeklebt oder gewalzt werden oder blasenfrei aufgeschmolzen, aufvulkanisiert oder gesintert werden. Somit wird auf einfache Weise erreicht, dass die zu isolierenden Bereiche einfach hergestellt werden und die Kontaktzonen für die Außenelektroden erst gar nicht isoliert werden.

Als besondere Vorteile ergeben sich mit der Erfindung eine gleichmäßige Schichtdicke auch an den Kanten, gegenüber extrem dünnen Schichten beim üblichen Lack an den Kanten. Weiterhin sind weniger Arbeitsschritte beim Isolieren notwendig, da das Maskieren der Stirnfläche und Kontaktbereiche und das Reinigen der Kontaktierungszone für die Außenelektroden entfällt. Die Prozesszeit kann damit auch erheblich verkürzt werden, da das vorher übliche Lackieren auch noch ein Trocknen und Aushärten nach sich zieht. Die erfindungsgemäße trockene Aufbringung des Klebebands erfolgt maßgenau und vorkonfektionierbar und führt zu sofort weiterverarbeitbaren Piezoaktoren ohne Druckstellen.

Ein Tape oder Band mit guter Haftfestigkeit und geeigneten Isolationseigenschaften kann, wie zuvor erwähnt, blasenfrei aufgeklebt, aufgewalzt, aufgeschmolzen oder aufgesintert werden, wobei auch eine Kombination aus mehreren der genannten Möglichkeiten ebenfalls ausführbar ist.

Zum Beispiel kann durch blasenfreies Aufwalzen auf der Fläche und ganz speziell an Kanten, eventuell mit gezielter Wärme und Andrücken oder Anwalzen eine vollständige Überdeckung hergestellt werden und im nächsten Schritt ein Ausformen der toleranzbehafteten Lage einer möglicherweise scharfen Kante durchgeführt werden, mit dem Ziel passgenau und in der Folie spannungsfrei die Kante zu überdecken. Dies kann in vorteilhafter Weise eventuell durch geeignete lokale Erwärmung des Klebebandes erfolgen, so dass eine dauerhafte, gute und blasenfreie Haftung sowie kriechspurverhindernde Abdeckung der Piezoaktoren erfolgt.

Das Klebeband kann auf einfache Weise von einer Rolle als Streifen zugeführt und dann vor dem oder beim Aufbringen auf den Piezoaktor zugeschnitten werden.

### Zeichnung

Ein Ausführungsbeispiel des erfindungsgemäßen Piezoaktors wird anhand der Zeichnung erläutert. Es zeigen:
Figur 1 einen Schnitt durch einen Piezoaktor mit einem Mehrschichtaufbau von Lagen aus Piezokeramik und Elektroden nach dem Stand der Technik und
Figur 2 eine Draufsicht auf den Lagenaufbau einer der Innenelektroden nach der Figur 1 mit einem Klebeband als Isolationsschicht.

### Beschreibung des Ausführungsbeispiels

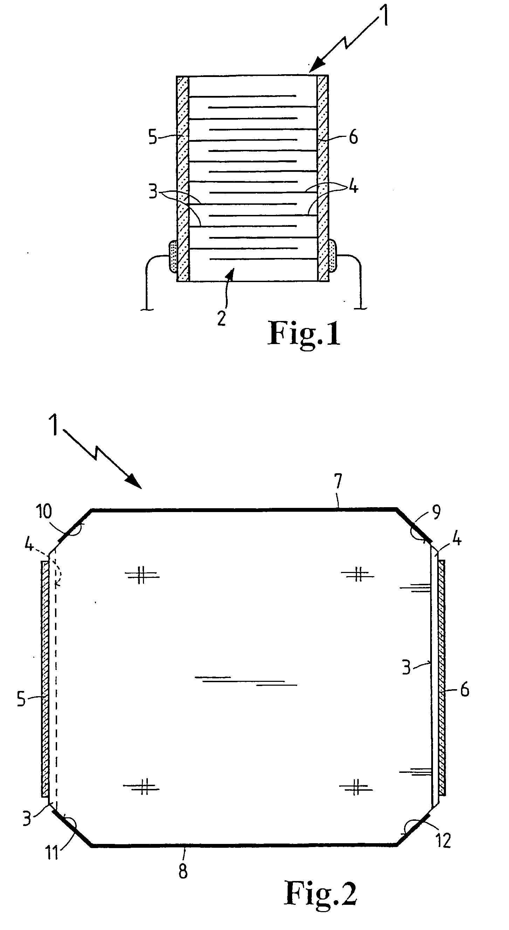

In Figur 1 ist ein Piezoaktor 1 im Prinzip nach dem Stand der Technik gezeigt, der in an sich bekannter Weise aus Piezofolien 2 eines Quarzmaterials mit einer geeigneten Kristallstruktur aufgebaut ist, so dass unter Ausnutzung des sogenannten Piezoeffekts bei Anlage einer äußeren elektrischen Spannung an Innenelektroden 3 und 4 über Kontaktflächen bzw. Außenelektroden 5 und 6 eine mechanische Reaktion des Piezoaktors 1 erfolgt.

In Figur 2 ist eine Draufsicht auf eine Innenelektrode 3 und eine durch eine gestrichelte Linie gekennzeichnete Innenelektrode 4 gezeigt, wobei zu erkennen ist, dass die Innenelektrode 3 links an die Außenelektrode 5 angeschlossen ist und die Innenelektrode 4 rechts an die Außenelektrode 6 angeschlossen ist. Erfindungsgemäß ist ein Klebeband 7 auf der einen Seite und ein Klebeband 8 auf der anderen Seite des Piezoaktors 1 aufgebracht.

Die Klebebänder 7 und 8 können durch blasenfreies Aufwalzen auf den seitlichen Flächen des Piezoaktors 1 und ganz speziell an Kanten 9, 10, 11 und 12 eventuell mit gezielter Wärme und Andrücken oder Anwalzen aufgetragen werden. Hiermit entsteht eine vollständige Überdeckung der nicht mit den Außenelektroden 5 und 6 versehenen Bereiche des Piezoaktors 1, so dass die Klebebänder 7 und 8 passgenau und spannungsfrei die Kanten 9 bis 12 überdecken. Dies kann auch durch eine geeignete lokale Erwärmung des jeweiligen Klebebandes 7 oder 8 an den Kanten 9 bis 12 unterstützt werden.

## Patentansprüche

1. Piezoaktor, mit
- einem Mehrschichtaufbau von Piezolagen (2) und dazwischen angeordneten Innenelektroden (3,4) und mit
- einer wechselseitigen Kontaktierung der Innenelektroden (3,4) mit Außenelektroden (5,6), wobei die Bereiche zwischen den Außenelektroden (5,6) mit einer geeigneten Isolation (7,8) versehen sind, **dadurch gekennzeichnet, dass**
- die Isolation eine Schicht aus einem haftendem Band (7,8) ist, die einen vorgegebenen Bereich zwischen den Außenelektroden (5,6) überdeckt.

2. Piezoaktor nach Anspruch 1, **dadurch gekennzeichnet, dass**
- das haftende Band ein Klebeband (7,8) ist.

3. Piezoaktor nach Anspruch 1 oder , **dadurch gekennzeichnet, dass**
- das Band oder Klebeband (7,8) aus einem vorkonfektionierten maßgenauen Material besteht.

4. Verfahren zur Herstellung eines Piezoaktors nach einem der vorhergehenden Ansprüche, **dadurch gekennzeichnet, dass**
- das Band (7,8) blasenfrei aufgeklebt oder gewalzt wird.

5. Verfahren zur Herstellung eines Piezoaktors nach einem der Ansprüche 1 bis 3, **dadurch gekennzeichnet, dass**
- das Band (7,8) blasenfrei aufgeschmolzen, aufvulkanisiert oder gesintert wird.

6. Verfahren nach Anspruch 4 oder 5, **dadurch gekennzeichnet, dass**
- das Band (7,8) durch lokale oder ganzflächige Erwärmung und/oder Andrücken oder Anwalzen aufgebracht wird.

7. Verfahren nach Anspruch 6, **dadurch gekennzeichnet, dass**
- insbesondere an den Ecken oder Kanten (9,10,11,12) des Piezoaktors (1) ein Ausformen der toleranzbehafteten Form der Ecken oder Kanten (9,10,11,12) durchgeführt wird.

8. Verfahren nach einem der Ansprüche 4 bis 7, **dadurch gekennzeichnet, dass**
- das Band (7,8) von einer Rolle als Streifen zugeführt wird und vorm oder beim Aufbringen auf den Piezoaktor (1) zugeschnitten wird.

## Claims

1. Piezo actuator, having
- a multilayer structure of piezo layers (2) and inner electrodes (3, 4) arranged between them, and having
- contact-connection between the inner electrodes (3, 4) and outer electrodes (5, 6) on alternate sides, the regions between the outer electrodes (5, 6) being provided with a suitable insulation (7, 8), **characterized in that**
- the insulation is a layer of a bonding tape (7, 8) which covers a predetermined region between the outer electrodes (5, 6).

2. Piezo actuator according to Claim 1, **characterized in that**
- the bonding tape is an adhesive tape (7, 8).

3. Piezo actuator according to Claim 1 or 2, **characterized in that**
- the tape or adhesive tape (7, 8) consists of a prefabricated dimensionally accurate material.

4. Process for producing a piezo actuator according to one of the preceding claims, **characterized in that**
- the tape (7, 8) is stuck or rolled on without any bubbles.

5. Process for producing a piezo actuator according to one of Claims 1 to 3, **characterized in that**
- the tape (7, 8) is fused, vulcanized or sintered on without any bubbles.

6. Process according to Claim 4 or 5, **characterized in that**
- the tape (7, 8) is applied by local or entire-surface heating and/or pressing-on or rolling-on.

7. Process according to Claim 6, **characterized in that**
- in particular at the corners or edges (9, 10, 11, 12) of the piezo actuator (1), the shape of the corners or edges (9, 10, 11, 12), which is subject to tolerances, is reshaped.

8. Process according to one of Claims 4 to 7, **characterized in that**
- the tape (7, 8) is supplied from a roll in strip form and is cut to match the shape and size of the piezo actuator (1) before or during application.

## Revendications

1. Actionneur piézoélectrique comprenant :
- une structure multicouche de couches piézoélectriques (2) avec entre celles-ci des électrodes intérieures (3, 4), et
- une mise en contact alternée des électrodes intérieures (3, 4) avec des électrodes extérieures (5, 6), les zones entre les électrodes extérieures (5, 6) étant munies d'une isolation (7, 8) appropriée,
**caractérisé en ce que**
l'isolation est une couche d'une bande adhésive (7, 8) qui recouvre une zone prédéfinie entre les électrodes extérieures (5, 6).

2. Actionneur piézoélectrique selon la revendication 1,
**caractérisé en ce que**
la bande adhésive est une bande de colle (7, 8).

3. Actionneur piézoélectrique selon la revendication 1 ou 2,
**caractérisé en ce que**
la bande ou bande de colle (7, 8) est réalisée à partir d'un matériau pré-confectionné aux dimensions précises.

4. Procédé de fabrication d'un actionneur piézoélectrique selon l'une des revendications précédentes,
**caractérisé en ce qu'**
on colle ou on lamine la bande (7, 8) sans bulle.

5. Procédé de fabrication d'un actionneur piézoélectrique selon l'une quelconque des revendications 1 à 3,
**caractérisé en ce que**
la bande (7, 8) est appliquée sans bulles par fusion, vulcanisation ou frittage.

6. Procédé selon la revendication 4 ou 5,
**caractérisé en ce que**
la bande (7, 8) est appliquée par chauffage local ou de toute la surface et/ ou par pression ou laminage.

7. Procédé selon la revendication 6,
**caractérisé en ce que**
notamment au niveau des coins ou des arêtes (9, 10, 11, 12) de l'actionneur piézoélectrique (1) on effectue un moulage de la forme tolérancée des coins ou des arêtes (9, 10, 11, 12).

8. Procédé selon l'une quelconque des revendications 4 à 7,
**caractérisé en ce qu'**
à partir d'une bobine on déroule la bande (7, 8) en forme de ruban, et on la découpe avant ou lors de l'application sur l'actionneur piézoélectrique (1).
